(19) **Europäisches Patentamt**

**European Patent Office**

**Office européen des brevets**

(11) **EP 1 429 376 A1**

(12) **EUROPEAN PATENT APPLICATION**
published in accordance with Art. 158(3) EPC

(43) Date of publication:
**16.06.2004 Bulletin 2004/25**

(51) Int Cl.⁷: **H01L 21/316**

(21) Application number: **02762905.4**

(86) International application number:
**PCT/JP2002/008756**

(22) Date of filing: **29.08.2002**

(87) International publication number:
**WO 2003/021658 (13.03.2003 Gazette 2003/11)**

(84) Designated Contracting States:
**AT BE BG CH CY CZ DE DK EE ES FI FR GB GR IE IT LI LU MC NL PT SE SK TR**

(30) Priority: **03.09.2001 JP 2001266019**

(71) Applicants:
• **TOKYO ELECTRON LIMITED**
  **Minato-ku, Tokyo 107-8481 (JP)**
• **JSR Corporation**
  **Tokyo 104-8410 (JP)**

(72) Inventors:
• **HISHIYA, Shingo, TOKYO ELECTRON LIMITED**
  **Tokyo 107-8481 (JP)**

• **SANO, Tetsuya, TOKYO ELECTRON LIMITED**
  **Tokyo 107-8481 (JP)**
• **SEKIGUCHI, Manabu, JSR Corporation**
  **Tokyo 104-8410 (JP)**
• **MITA, Michihiro, JSR Corporation**
  **Tokyo 104-8410 (JP)**

(74) Representative: **Schrell, Andreas, Dr. et al**
  **Gleiss & Grosse**
  **Leitzstrasse 45**
  **70469 Stuttgart (DE)**

(54) **METHOD AND APPARATUS FOR PROCESSING ORGANOSILOXANE FILM**

(57) A method of processing an organosiloxane film includes loading, into a reaction container (1), a substrate (W) with a coating film of a polysiloxane base solution applied thereon. The solution contains bond of a silicon atom with a functional group selected from the group consisting of a methyl group, phenyl group, and vinyl group. The method also includes subjecting the substrate (W) to a heat process in the reaction container (1) to bake the coating film. The heat process is performed in a process atmosphere that includes a catalytic agent gas containing a mixture of ammonia and water, at a process temperature of from 300 to 400°C.

FIG. 1

## Description

Technical Field

The present invention relates to a method and apparatus for processing an organosiloxane film by performing a heat process on a substrate with a coating film of a polysiloxane base solution applied thereon, thereby baking the coating film.

Background Art

In recent years, due to demands for improvement in performance of semiconductor devices (semiconductor structures), copper is used as an interconnection line material, because it is low in resistivity and high in electromigration resistance property (EM resistance property). A process called damascene process is known as one of the methods for realizing a multi-layered structure with interconnection lines made of copper. According to this process, a recess for embedding an interconnection line is formed in an insulating film, and then the recess is filled with copper. Then, the substrate surface is polished by means of CMP (Chemical Mechanical Polishing) to remove a part of the copper out of the recess. This process is repeated, thereby realizing a multi-layered structure.

From a generation having a pattern line width of 0.10 μm, it is thought effective to use a dual-damascene process, in which an interconnection line groove and a via-hole connected thereto from below are filled with an interconnection line material together. As the number of layers in a multi-layered structure with interconnection lines increases, the films on the lower side repeatedly receive heat processes as its thermal history. Accordingly, it is necessary to reduce the number of heat processes to as few as possible. Furthermore, since heat processes may change the profile in impurity concentration of a transistor or the like, they should be performed at a lower temperature and for a shorter time.

Disclosure of Invention

An object of the present invention is to provide a method and apparatus for forming, at a low process temperature, a film that can be used as an inter-level insulating film with a low dielectric constant.

According to a first aspect of present invention, there is provided a method of processing an organosiloxane film, the method comprising:

loading, into a reaction container, a substrate with a coating film of a polysiloxane base solution applied thereon, the solution containing a bond of a silicon atom with a functional group selected from the group consisting of a methyl group, phenyl group, and vinyl group; and

subjecting the substrate to a heat process in the reaction container to bake the coating film, the heat process being performed in a process atmosphere that includes a catalytic agent gas containing a mixture of ammonia and water, at a process temperature of from 300 to 400°C.

According to a second aspect of present invention, there is provided a method of processing an organosiloxane film, the method comprising:

loading, into a reaction container, a substrate with a coating film of a polysiloxane base solution applied thereon, the solution containing a bond of a silicon atom with a functional group selected from the group consisting of a methyl group, phenyl group, and vinyl group; and
subjecting the substrate to a heat process in the reaction container to bake the coating film, the heat process being performed in a process atmosphere that includes a catalytic agent gas selected from the group consisting of dinitrogen oxide and hydrogen, at a process temperature of from 300 to 400°C.

According to a third aspect of present invention, there is provided an apparatus for processing an organosiloxane film by subjecting a substrate to a heat process to bake a coating film of a polysiloxane base solution applied thereon, the solution containing a bond of a silicon atom with a functional group selected from the group consisting of a methyl group, phenyl group, and vinyl group, the apparatus comprising:

a reaction container configured to accommodate the substrate;
a gas supply system configured to supply an employed gas into the reaction container, and including a supply source of ammonia gas;
a heater configured to heat the substrate in the reaction container; and
a control section configured to control the gas supply system and the heater,

wherein, when subjecting the substrate to the heat process in the reaction container, the control section controls the gas supply system and the heater to perform the heat process in a process atmosphere that includes a catalytic agent gas containing a mixture of ammonia and water, at a process temperature of from 300 to 400°C.

According to a fourth aspect of present invention, there is provided an apparatus for processing an organosiloxane film by subjecting a substrate to a heat process to bake a coating film of a polysiloxane base solution applied thereon, the solution containing a bond of a silicon atom with a functional group selected from the group consisting of a methyl group, phenyl group, and vinyl group, the apparatus comprising:

a reaction container configured to accommodate the substrate;

a gas supply system configured to supply an employed gas into the reaction container, and including a supply source of a gas selected from the group consisting of dinitrogen oxide and hydrogen;

a heater configured to heat the substrate in the reaction container; and

a control section configured to control the gas supply system and the heater,

wherein, when subjecting the substrate to the heat process in the reaction container, the control section controls the gas supply system and the heater to perform the heat process in a process atmosphere that includes a catalytic agent gas selected from the group consisting of dinitrogen oxide and hydrogen, at a process temperature of from 300 to 400°C.

Brief Description of Drawings

FIG. 1 is a sectional side view showing a vertical heat-processing apparatus according to an embodiment of the present invention;

FIG. 2 is a graph showing the relationship between coating film baking temperature and the dielectric constant of an obtained inter-level insulating film;

FIG. 3 is a graph showing the relationship between coating film baking time and the dielectric constant of an obtained inter-level insulating film; and

FIG. 4 is a graph showing the relationship between coating film baking temperature and the dielectric constant of an obtained inter-level insulating film.

Best Mode for Carrying Out the Invention

Inter-level insulating films disposed in a multi-layered structure with interconnection lines are required to have a lower relative dielectric constant, in accordance with an increase in the operational speed of the device. As a method of forming an inter-level insulating film with a low dielectric constant, there is a method of applying an organic base material containing silicon onto a semiconductor wafer, and baking the coating film thus formed. The present inventors studied polysiloxane base solutions for use as an organic base material of this kind. According to experiments, it has been confirmed that, where such a solution is applied onto a wafer by spin-coating, and the coating film thus formed is baked in a nitrogen ($N_2$) gas atmosphere at a baking temperature of 400°C or more for 60 minutes or more, an inter-level insulating film with a low dielectric constant is obtained.

However, a problem has been found in that, where a polysiloxane base solution is used, if a low process temperature and a short process time are used, an insulating film with a low dielectric constant can hardly be obtained. This problem seems to be caused by the following mechanism. Specifically, the baking step (or heat-processing step) is used to cause (-SiOH)'s present in an applied coating liquid to inter-react with each other, thereby producing (-Si-O-Si-)'s. If the coating film is supplied with insufficient thermal energy, the reaction described above cannot propagate through the entire coating film. As a consequence, a large number of (-SiOH)'s remain in the film, which hinders decrease in the dielectric constant.

Embodiments of the present invention achieved on the basis of the findings given above will now be described with reference to the accompanying drawings.

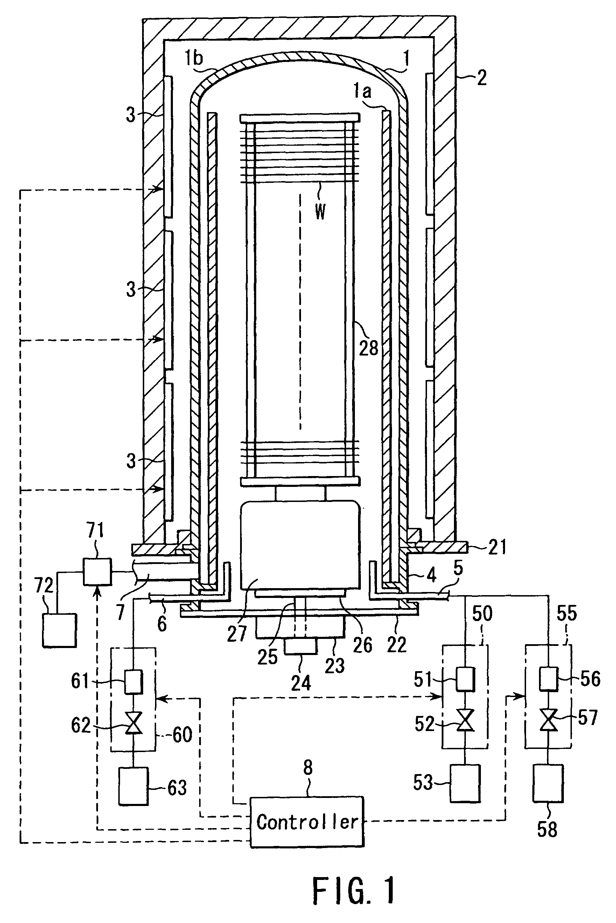

FIG. 1 is a sectional side view showing a vertical heat-processing apparatus according to an embodiment of the present invention. This apparatus has a reaction tube 1 having a double-tube structure made of quartz, which is formed of an inner tube 1a whose opposite ends are opened, and an outer tube 1b whose top end is closed. A cylindrical thermal insulator 2 is disposed around the reaction tube 1 and fixed on a base body 21. The thermal insulator 2 is provided with a heating means or heater 3 disposed on the inner side. The heater 3 is formed of resistance heating bodies arranged independently of each other in the vertical direction (three stages in the example shown in FIG. 1).

The inner tube 1a and outer tube 1b are supported on a cylindrical manifold 4 at their bottoms. A first gas supply line 5 and a second gas supply line 6 are connected to the manifold 4, such that they have their supply ports opened in the lower area inside the inner tube 1a. In this embodiment, the first gas supply line 5 is combined with gas supply control sections 50 and 55 and so forth to form a first gas supply system. The second gas supply line 6 is combined with gas supply control section 60 and so forth to form a second gas supply system.

More specifically, the first gas supply line 5 is connected to an ammonia gas supply source 53 through the gas supply control section (ammonia gas supply control section) 50, which includes a flow rate adjustment unit 51 and a valve 52. The first gas supply line 5 is also connected to an inactive gas supply source 58 through the gas supply control section 55, which includes a flow rate adjustment unit 56 and a valve 57. On the other hand, the second gas supply line 6 is connected to a water vapor supply source 63 through the gas supply control section 60, which includes a flow rate adjustment unit 61 and a valve 62.

An exhaust line 7 is connected to the manifold 4 to perform exhaust through the space between the inner tube 1a and outer tube 1b. The exhaust line 7 is connected to a vacuum pump 72 through a pressure adjustment unit 71, such as a butterfly valve. In this embodiment, the inner tube 1a, outer tube 1b, and manifold 4 form a reaction container.

A lid body 22 is provided to close the bottom port of the manifold 4. The lid body 22 is attached to a boat elevator 23. A rotary table 26 is disposed on the lid body 22 through a rotary shaft 25, which is rotated by a drive 24. An insulating cylinder or thermal insulation unit 27 is disposed on the rotary table 26 to mount a substrate holder or wafer boat 28 thereon. The wafer boat 28 is configured to support a number of wafers W at intervals in the vertical direction.

The vertical heat-processing apparatus includes a control section 8. The control section 8 controls the heater 3, pressure adjustment unit 71, and gas supply control sections 50, 55, and 60 in accordance with a predetermined program stored in a memory built therein.

Next, an explanation will be given of a method of processing an organosiloxane film according to an embodiment of the present invention, which is performed using the vertical heat-processing apparatus shown in FIG. 1. This process is performed on a target substrate (semiconductor wafer) with a coating film of a polysiloxane base solution formed thereon. The coating film has been applied to the substrate by, e.g., spin-coating, and then dried. The solution is a compound containing a bond of a silicon atom with a functional group selected from the group consisting of a methyl group ($-CH_3$), phenyl group ($-C_6H_5$), and vinyl group ($-CH=CH_2$).

The polysiloxane is prepared by hydrolysing a silane compound having a hydrolyte group under the existence or non-existence of a catalytic agent to condense it. A preferable example of a silane compound containing a hydrolyte group is trimethoxysilane, triethoxysilane, methyltrimethoxysilane, methyltriethoxysilane, methyltri-n-propoxysilane, methyltri-iso-propoxysilane, ethyltrimethoxysilane, ethyltriethoxysilane, vinyltrimethoxysilane, vinyltriethoxysilane, phenyltrimethoxysilane, phenyltriethoxysilane, dimethyldimethoxysilane, dimethyldiethoxysilane, diethyldimethoxysilane, diethyldiethoxysilane, diphenyldimethoxysilane, diphenyldiethoxysilane, tetramethoxysilane, tetraethoxysilane, tetra-n-propoxysilane, tetra-isopropoxysilane, tetra-n-butoxysilane, tetra-sec-butoxysilane, tetra-tert-butoxysilane, or tetraphenoxysilane.

A catalytic agent used in hydrolysis can be an acid, chelate compound, or alkali, and preferably an alkali, such as ammonia or alkylamine.

The molecular weight of polysiloxane is 100,000 to 10,000,000, preferably 100,000 to 9,000,000, and more preferably 200,000 to 8,000,000 in weight-average molecular weight obtained by polystyrene conversion in accordance with a GPC method. Where it is less than 50,000, the dielectric constant and elastic modulus may be insufficient. Where it is greater than 10,000,000, the uniformity of a coating film may be lowered.

It is preferable to use a polysiloxane base solution that satisfies the following formula.

$0.9 \geqq R/Y \geqq 0.2$ (where R denotes the atomicity of the methyl group, phenyl group, or vinyl group, and Y denotes the atomicity of Si, both in polysiloxane).

The polysiloxane base solution (coating liquid) is prepared by dissolving such polysiloxane into an organic solvent. A concrete example of a solvent to be used for this is at least one selected from the group consisting of an alcohol base solvent, ketone base solvent, amide base solvent, and ester base solvent. In addition to polysiloxane, the coating liquid may contain an arbitrary component, such as surfactant, or pyrolytic polymer, as needed.

A number of, e.g., 150, wafers W each with the coating film thus formed are placed on the wafer boat 28, which is then moved up by the elevator 23 and loaded into the reaction container formed of the reaction tube 1 and manifold 4. The reaction container has been kept at, e.g., a process temperature used in a heat process to be performed. However, since the reaction container temporarily decreases in temperature due to the wafer boat 28 being loaded, it waits until the temperature becomes stable at the process temperature. The process temperature is the temperature of a region where the wafers W to be used as products are placed. The process temperature is set to fall in a range of from 300 to 400°C, and preferably of from 300 to 380°C. The reaction container is vacuum-exhausted and set to have a predetermined pressure-reduced atmosphere by the pressure adjustment unit 71, by the timing when the temperature inside the reaction container becomes stable.

When the reaction container becomes stable at the process temperature and has the predetermined pressure-reduced atmosphere, an employed gas is supplied into the reaction container to perform baking (a heat process) on the coating film. At this time, the valve 52 of the gas supply control section 50 is opened to supply ammonia gas into the reaction container at a predetermined flow rate adjusted by the flow rate adjustment unit 51. Also, the valve 62 of the gas supply control section 60 is opened to supply water vapor into the reaction container at a predetermined flow rate adjusted by the flow rate adjustment unit 61. After the heat process is performed for a predetermined time, the valve 57 of the gas supply control section 55 is opened to supply, e.g., nitrogen gas into the reaction container. By doing so, the interior of the reaction container is returned to atmospheric pressure, and then the lid body 22 is moved down to transfer out the wafer boat 28. These serial operations are performed by the control section 8 in accordance with a predetermined program.

During the heat process described above, a trace amount of water ($H_2O$) present in the reaction container reacts with ammonia ($NH_3$), thereby producing $NH_4^+$ and $OH^-$. It is though that the $NH_4^+$ and $OH^-$ and non-reacted $H_2O$ work as a catalytic agent so as to make ($-SiOH$)'s in the coating film react with each other as described blow and cause dehydration condensation-polymerization, thereby producing (-Si-O-Si-)'s.

$$-SiOH + HOSi- \rightarrow -Si-O-Si-$$

The concentrations of ammonia and water in the process atmosphere in the reaction container are set in light of factors to obtain the catalytic agent effect described above and to prevent ill effects on the target objects. More specifically, the ammonia concentration in the process atmosphere is set to be preferably from 0.004 to 5.0%, more preferably from 0.04 to 2.0%. The water concentration in the process atmosphere is set to be preferably from 0.00005 to 4.0%, more preferably from 0.00005 to 0.15%.

In this embodiment, the water vapor is supplied from the outside. In practice, however, since the atmosphere in the reaction container cannot completely be exhausted, a trace amount of moisture is present in the reaction container. As a consequence, even if no water vapor is supplied into the reaction container, an inter-level insulating film with a low dielectric constant can be obtained, as shown in the experimental examples described later. However, where the number of wafers to be processed as a batch is large, the moisture may be insufficient. Accordingly, as shown in FIG. 1, the apparatus preferably has a structure for supplying water vapor into the reaction container, as needed.

As regards supply of water vapor, when the temperature of the heat process atmosphere becomes a predetermined temperature, only water vapor may be supplied first, followed by ammonia gas being supplied thereafter. Where only water vapor is supplied, the supply time is set to be, e.g., from 30 seconds to 10 minutes, and preferably from 1 minute to 5 minutes.

For example, where the wafer boat 28 accommodates 170 wafers W of 8-inch (including dummy wafers placed at the top and bottom sides), as a fully loaded number of wafers thereon, to perform a process, the reaction container comes to have a volume of from 100 to 250L. For this reaction container, the flow rate of ammonia gas is set to be preferably from 0.01 SLM to 5 SLM, and more preferably from 0.1 SLM to 2 SLM. The flow rate of water vapor is set to be 0.001 CCM to 3 CCM in liquid conversion flow rate.

In order to study the influence of pressure on the dielectric constant of an inter-level insulating film, heat processes were performed while using different pressures in the reaction container in a range of from 0.15 kPa to 90 kPa. No substantial variations in the dielectric constant due to the pressure were observed. Accordingly, any one of a pressure-reduced atmosphere, normal pressure atmosphere, and pressure-increased atmosphere may be used as the process atmosphere.

When ammonia gas is supplied into the reaction container, an inactive gas, such as nitrogen gas, may be supplied together. This is advantageous if a large quantity of oxidizing components, such as oxygen, may be left in the reaction container, because the inactive gas can suppress the level of oxidizing atmosphere in oxidizing the coating film, thereby preventing an ill effect of the oxidizing atmosphere. However, as shown in the experimental examples described later, even if no inactive gas is supplied along with ammonia gas, no problem arises in the experiment-level results. Accordingly, supply of inactive gas is not an essential factor.

As the time period of the heat process, 5 minutes or more is sufficient for 350°C, as shown in the experimental examples described later. However, if the heat process is too long, films disposed on the lower side may be affected by the thermal history. Accordingly, the time period of the heat process is preferably set at 60 minutes or less.

The vertical heat-processing apparatus described above employs the reaction tube that has a double-tube structure. Alternatively, for example, the reaction tube may be formed of a single-tube structure, which is exhausted from the top.

According to this embodiment, when a polysiloxane base coating film is baked to form an inter-level insulating film, ammonia and water (water vapor supplied into the reaction container or moisture left in the reaction container) exert a catalytic agent effect to reduce the activation energy necessary for the baking reaction. As a consequence, even if the heat process temperature is low, or the heat process time (baking time) is short, the baking reaction sufficiently proceeds, thereby obtaining an inter-level insulating film with a low dielectric constant. Accordingly, it is possible to provide properties of an inter-level insulating film required for devices in a generation having a pattern line width of 0.10 μm, such as a dual-damascene structure. Furthermore, it is possible to prevent a device structure formed in advance from being affected by heat.

Next, an explanation will be given of a method of processing an organosiloxane film according another embodiment of the present invention. In this embodiment, dinitrogen oxide ($N_2O$) gas or hydrogen ($H_2$) gas is used, instead of ammonia gas, as a gas supplied from the first gas supply line 5 into the reaction tube 1. Accordingly, a vertical heat-processing apparatus used for performing a method according this embodiment is structured such that the gas supply source 53 connected to the first gas supply line 5 in the vertical heat-processing apparatus shown in FIG. 1 is replaced with a supply source of dinitrogen oxide gas or hydrogen gas. The second gas supply line 6 is unnecessary.

As shown in experimental examples described later, this embodiment also makes it possible to obtain an inter-level insulating film with a low dielectric constant, as in the case of ammonia gas being used. In this case, it is though that the following catalytic agent causes dehydration condensation-polymerization reaction, as described above. Where dinitrogen oxide gas is used, the dinitrogen oxide gas, which is a kind of acid, itself works as the catalytic agent. Where hydrogen gas is used, the hydrogen gas, which is a kind of acid, itself works as the catalytic agent. This condition allows a process to reduce the activation energy necessary for obtaining an inter-level insulating film. As a consequence, even if the baking temperature is low, or the baking time is short, the baking reaction sufficiently proceeds.

The concentration of dinitrogen oxide gas or hydrogen gas in the process atmosphere in the reaction container is set in light of factors to obtain the catalytic agent effect described above and to prevent ill effects on the target objects. More specifically, where dinitrogen oxide is used as a catalytic agent gas, dinitrogen oxide concentration in the process atmosphere is set to be preferably from 0.004 to 5.0%, more preferably from 0.04 to 2.0%. Where hydrogen is used as a catalytic agent gas, hydrogen concentration in the process atmosphere is set to be preferably from 0.004 to 5.0%, more preferably from 0.04 to 2.0%.

Where dinitrogen oxide gas or hydrogen gas is used, heat process conditions are as follows: The baking temperature is set to be preferably 400°C or less, and more preferably 380°C or less. In light of baking of a coating film, the baking temperature is set to be 300°C or more. The baking time is set to be preferably from 5 minutes to 60 minutes, and more preferably from 10 minutes to 30 minutes. The pressure in the reaction tube 1 during baking is set to be preferably from 0.00039 kPa to 101.3 kPa, and more preferably from 0.15 kPa to 90 kPa.

As described above, where the reaction container accommodates 170 wafers W of 8-inch, the reaction container comes to have a volume of from 100 to 250L. For this reaction container, the flow rate of dinitrogen oxide gas is set to be preferably from 0.01 SLM to 5 SLM, and more preferably from 0.1 SLM to 2 SLM. The flow rate of hydrogen gas is set to be preferably from 0.01 SLM to 5 SLM, and more preferably from 0.1 SLM to 2 SLM. Both dinitrogen oxide gas and hydrogen gas may be supplied together.

Furthermore, when dinitrogen oxide gas or hydrogen gas is supplied, or dinitrogen oxide gas and hydrogen gas are supplied, into the reaction container, an inactive gas, such as nitrogen gas, may be supplied together with the former gas.

(Present example 1)

An experiment was conducted, using a vertical heat-processing apparatus having a reaction tube formed of a single-tube structure. In this experiment, 20 wafers W were placed on a wafer boat as heat process targets. The pressure in the reaction tube was set at 13.3 kPa, and ammonia gas was supplied at a flow rate of 2 SLM. Heat processes (baking) were performed at six different heat process temperatures of 300°C, 330°C, 340°C, 350°C, 380°C, and 420°C, each for 30 minutes. No water vapor was supplied into the reaction tube.

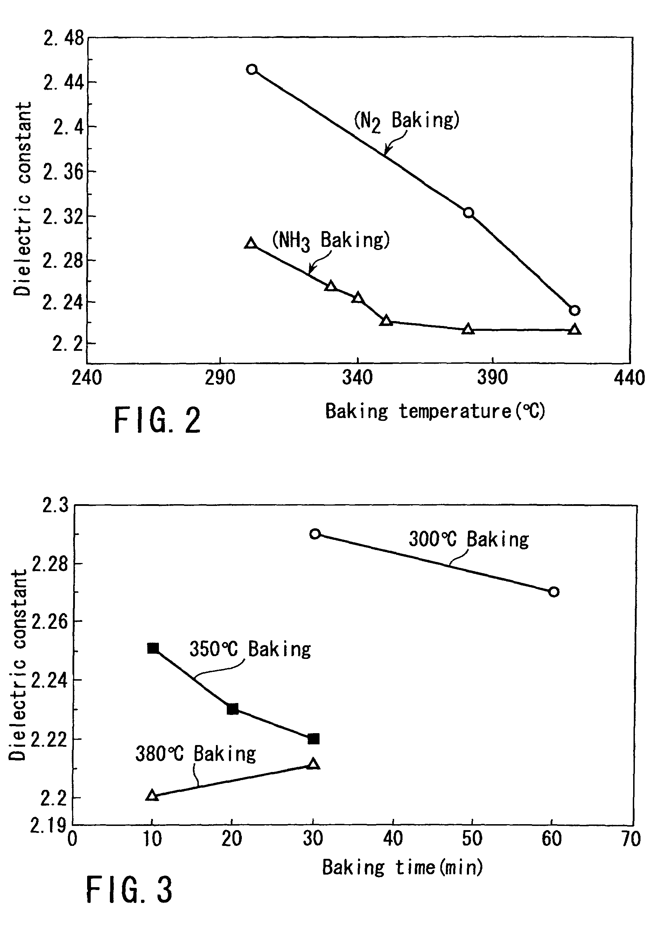

The molecular weight of polysiloxane in a solution (coating liquid) applied on each wafer W was 820,000 in weight-average molecular weight obtained by polystyrene conversion. The ratio $(CH_3/Si)$ of methyl group atomicity relative to silicon atomicity in polysiloxane was 0.5. Then, measurement was performed on the relative dielectric constant of insulating films thus obtained (a film to be used as an inter-level insulating film in an actual product wafer). As a result, the relationship between the heat process temperature and relative dielectric constant rendered a plot indicated with "$\Delta$" in FIG. 2.

For the measurement of the relative dielectric constant, an aluminum electrode pattern was formed on an obtained insulating film to prepare a sample. Then, the relative dielectric constant of the insulating film sample was measured by a CV method, at a frequency of 100 kHz, using "HP16451B electrode and HP4284A precision LCR meter" manufactured by Yokogawa-Hewlett-Packard Co.

(Comparative example 1)

Instead of ammonia gas, nitrogen $(N_2)$ gas was supplied at a flow rate of 10 SLM. Heat processes (baking) were performed at three different heat process temperatures of 300°C, 380°C, and 420°C, where the process time was 30 minutes at 300°C and 380°C, and 60 minutes at 420°C. The other conditions were set to be the same as those in the present example 1. Measurement was performed on the relative dielectric constant of insulating films thus obtained, as in the present example 1. As a result, the relationship between the heat process temperature and relative dielectric constant rendered a plot indicated with "$\bigcirc$" in FIG. 2.

(Speculation)

It is thought that, where an inter-level insulating film has a relative dielectric constant of 2.3 or less, the film is well prepared to handle a high operation speed. A method according to the present invention makes it possible to attain an expected relative dielectric constant, even where a temperature as low as 300°C is used. In other words, looking only at the relative dielectric constant, it is possible to obtain an excellent insulating film with a very low relative dielectric constant, where the heat process temperature is set at 420°C. If the temperature is too high, however, a device structure formed in advance is affected, thereby hindering a process using dual-damascene to manufacture a device having a multi-layered structure. Accordingly, it is likely necessary to set the heat process temperature at 400°C or less.

Where ammonia gas was used, the insulating film showed a relative dielectric constant far smaller than that of a conventional case where nitrogen gas was used, at the same heat process temperature of 380°C or less. Where nitrogen gas was used, a heat process temperature of about 400°C or more was needed to attain a relative dielectric constant of 2.3 or less. Judging from these results, it has been found that a method according to the present invention can lower the heat process temperature, and provide a far better result, as compared to the case of nitrogen gas being used.

(Present example 2)

Heat processes were performed at a heat process temperature of 300°C for two different heat process times of 30 minutes and 60 minutes. The other conditions were set to be the same as those in the present example 1. Measurement was performed on the relative dielectric constant of insulating films thus obtained, as in the present example 1. As a result, the relationship between the baking time and relative dielectric constant rendered a plot indicated with "○" in FIG. 3.

(Present example 3)

Heat processes were performed at a heat process temperature of 350°C for three different heat process times of 10 minutes, 20 minutes, and 30 minutes. The other conditions were set to be the same as those in the present example 1. Measurement was performed on the relative dielectric constant of insulating films thus obtained, as in the present example 1. As a result, the relationship between the baking time and relative dielectric constant rendered a plot indicated with "■" in FIG. 3.

(Present example 4)

Heat processes were performed at a heat process temperature of 380°C for two different heat process times of 10 minutes and 30 minutes. The other conditions were set to be the same as those in the present example 1. Measurement was performed on the relative dielectric constant of insulating films thus obtained, as in the present example 1. As a result, the relationship between the baking time and relative dielectric constant rendered a plot indicated with "△" in FIG. 3.

(Speculation)

As shown in FIG. 3, a higher heat process temperature resulted in a lower relative dielectric constant of an insulating film for the same heat process time. At 350°C, even through the heat process time was 10 minutes, the relative dielectric constant took on a sufficiently low value of 2.25. At 300°C, the relative dielectric constant became 2.29 at 30 minutes. Accordingly, it is estimated that 300°C requires a longer heat process time than 350°C to obtain a predetermined relative dielectric constant. However, it is thought that, where the heat process temperature is lower, heat has a far smaller ill effect on a device structure below an inter-level insulating film.

(Present example 5)

A heat process was performed at a heat process temperature of 380°C while supplying water vapor at a flow rate of 0.0001 LM (0.1 CCM) in liquid conversion, along with ammonia gas, into a reaction container. The other conditions were set to be the same as those in the present example 1. Measurement was performed on the relative dielectric constant of an insulating film thus obtained, as in the present example 1. As a result, the relative dielectric constant of the insulating film was 2.25.

Judging from the result, it has been found that water vapor does not necessarily have to be supplied into a reaction container in a case where moisture is left in the reaction container, and, if anything, excessive moisture has an ill effect on the relative dielectric constant of an insulating film.

(Present example 6)

An experiment was conducted, using a vertical heat-processing apparatus having a reaction tube formed of a single-tube structure. In this experiment, 20 wafers W were placed on a wafer boat as heat process targets. In a first example, the pressure in the reaction tube was set at 13.3 kPa, and dinitrogen oxide gas was supplied at a flow rate of 2 SLM. In a second example, the pressure in the reaction tube was set at 0.15 kPa, and hydrogen gas was supplied at a flow rate of 2 SLM. In either case, a heat process (baking) was performed at a process temperature of 350°C for 30 minutes. No inactive gas was supplied into the reaction tube.

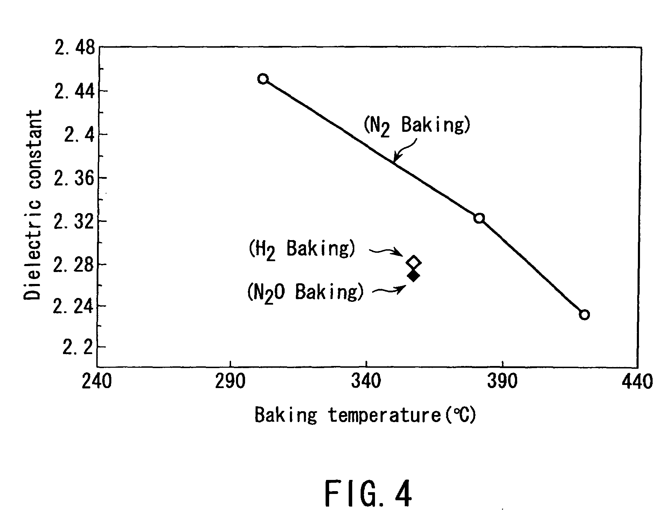

Measurement was performed on the relative dielectric constant of insulating films thus obtained (a film to be used as an inter-level insulating film in an actual product wafer), as in the present example 1. As a result, the relationship between the heat process temperature and relative dielectric constant rendered a plot indicated with "♦" in FIG. 4 for dinitrogen oxide gas, and a plot indicated with "◊" in FIG. 4 for hydrogen gas. A plot indicated with "○" in FIG. 4 denotes the relationship between the heat process temperature and relative dielectric constant obtained in the comparative example 1 where heat processes were performed, using nitrogen gas.

(Speculation)

As shown in FIG. 4, where dinitrogen oxide gas or hydrogen gas was used as a gas (baking reaction promotion gas) supplied into the reaction tube during baking, even though the baking temperature was as low as 350°C, the relative dielectric constant of an insulating film formed on a wafer W became lower than that obtained by a heat process using nitrogen gas. At this baking temperature, the relative dielectric constant of an insulating film was 2.27 by dinitrogen oxide gas, and 2.28 by hydrogen gas, i.e., both of which were as low as 2.3 or less. Such a low relative dielectric constant was obtained under a baking temperature of 400°C or less, which is preferable in consideration of its influence on a device structure formed in advance, as described above.

Although no examples are shown where different baking temperatures were used in this case, it can be seen from FIG. 2 that the relative dielectric constant of an insulating film decreased with an increase in baking temperature in either case where the baking reaction promotion gas was nitrogen gas or ammonia gas. Based on this, it can be estimated that the relative dielectric constant will also decrease with an increase in baking temperature, in the case of dinitrogen oxide gas or hydrogen gas being used as a catalytic agent gas. Accordingly, it has been found that, also where dinitrogen oxide gas or hydrogen gas is used as a catalytic agent gas, the relative dielectric constant of an insulating film can be lower, and the heat process temperature can be lower, as compared to the case of nitrogen gas being used.

Industrial Applicability

According to the present invention, where a polysiloxane base coating film formed on a substrate is heat-processed to form an inter-level insulating film, the inter-level insulating film can have a low dielectric constant, even if a low heat process temperature is used.

**Claims**

1. A method of processing an organosiloxane film, the method comprising:

   loading, into a reaction container, a substrate with a coating film of a polysiloxane base solution applied thereon, the solution containing a bond of a silicon atom with a functional group selected from the group consisting of a methyl group, phenyl group, and vinyl group; and subjecting the substrate to a heat process in the reaction container to bake the coating film, the heat process being performed in a process atmosphere that includes a catalytic agent gas containing a mixture of ammonia and water, at a process temperature of from 300 to 400°C.

2. The method according to claim 1, wherein the process atmosphere has a ammonia concentration of from 0.004 to 5.0%, and a water concentration of from 0.00005 to 4.0%.

3. The method according to claim 1, wherein the process atmosphere includes ammonia derived from ammonia gas supplied into the reaction container during the heat process, and the process atmosphere includes water derived from water existing in the reaction container before the heat process.

4. The method according to claim 1, wherein the process atmosphere includes ammonia and water derived from ammonia gas and water vapor supplied into the reaction container during the heat process.

5. A method of processing an organosiloxane film, the method comprising:

   loading, into a reaction container, a substrate with a coating film of a polysiloxane base solution applied thereon, the solution containing a bond of a silicon atom with a functional group selected from the group consisting of a methyl group, phenyl group, and vinyl group; and subjecting the substrate to a heat process in the reaction container to bake the coating film, the heat process being performed in a process atmosphere that includes a catalytic agent gas selected from the group consisting of dinitrogen oxide and hydrogen, at a process temperature of from 300 to 400°C.

6. The method according to claim 5, wherein the catalytic agent gas is dinitrogen oxide, and the process atmosphere has a dinitrogen oxide concentration of from 0.004 to 5.0%.

7. The method according to claim 5, wherein the catalytic agent gas is hydrogen, and the process atmosphere has a hydrogen concentration of from 0.004 to 5.0%.

8. The method according to claim 5, wherein the catalytic agent gas in the process atmosphere is derived from a gas supplied into the reaction container during the heat process.

9. The method according to claim 1 or 5, wherein an inactive gas is supplied into the reaction container during the heat process.

10. The method according to claim 1 or 5, wherein the solution contains polysiloxane by a molecular weight of 100,000 or more in weight-average molecular weight obtained by polystyrene conversion.

11. The method according to claim 1 or 5, wherein the solution contains polysiloxane that satisfies $0.9 \geqq R/Y \geqq 0.2$ (where R denotes atomicity of the methyl group, phenyl group, or vinyl group, and Y denotes atomicity of Si, both in polysiloxane).

**12.** An apparatus for processing an organosiloxane film by subjecting a substrate to a heat process to bake a coating film of a polysiloxane base solution applied thereon, the solution containing a bond of a silicon atom with a functional group selected from the group consisting of a methyl group, phenyl group, and vinyl group, the apparatus comprising:

a reaction container configured to accommodate the substrate;
a gas supply system configured to supply an employed gas into the reaction container, and including a supply source of ammonia gas;
a heater configured to heat the substrate in the reaction container; and
a control section configured to control the gas supply system and the heater,

wherein, when subjecting the substrate to the heat process in the reaction container, the control section controls the gas supply system and the heater to perform the heat process in a process atmosphere that includes a catalytic agent gas containing a mixture of ammonia and water, at a process temperature of from 300 to 400°C.

**13.** An apparatus for processing an organosiloxane film by subjecting a substrate to a heat process to bake a coating film of a polysiloxane base solution applied thereon, the solution containing a bond of a silicon atom with a functional group selected from the group consisting of a methyl group, phenyl group, and vinyl group, the apparatus comprising:

a reaction container configured to accommodate the substrate;
a gas supply system configured to supply an employed gas into the reaction container, and including a supply source of a gas selected from the group consisting of dinitrogen oxide and hydrogen;
a heater configured to heat the substrate in the reaction container; and
a control section configured to control the gas supply system and the heater,

wherein, when subjecting the substrate to the heat process in the reaction container, the control section controls the gas supply system and the heater to perform the heat process in a process atmosphere that includes a catalytic agent gas selected from the group consisting of dinitrogen oxide and hydrogen, at a process temperature of from 300 to 400°C.

**14.** The apparatus according to claim 12 or 13, wherein the gas supply system includes a supply source of an inactive gas, and the control section controls the gas supply system to supply an inactive gas into the reaction container during the heat process.

FIG. 1

FIG. 2

FIG. 3

FIG. 4

<div align="center">

**INTERNATIONAL SEARCH REPORT**

</div>

| International application No. |
| --- |
| PCT/JP02/08756 |

**A. CLASSIFICATION OF SUBJECT MATTER**
    Int.Cl⁷  H01L21/316

According to International Patent Classification (IPC) or to both national classification and IPC

**B. FIELDS SEARCHED**

Minimum documentation searched (classification system followed by classification symbols)
    Int.Cl⁷  H01L21/316

Documentation searched other than minimum documentation to the extent that such documents are included in the fields searched
    Jitsuyo Shinan Koho        1922–1996    Toroku Jitsuyo Shinan Koho    1994–2002
    Kokai Jitsuyo Shinan Koho  1971–2002    Jitsuyo Shinan Toroku Koho    1996–2002

Electronic data base consulted during the international search (name of data base and, where practicable, search terms used)

**C. DOCUMENTS CONSIDERED TO BE RELEVANT**

| Category* | Citation of document, with indication, where appropriate, of the relevant passages | Relevant to claim No. |
| --- | --- | --- |
| X | EP 643025 A1  (Dow Corning Corp.),<br>15 March, 1995 (15.03.95),<br>Full text<br>& JP 7-165413 A        & US 5320868 A<br>& CA 2117591 A | 1–14 |
| X | EP 647965 A1  (Dow Corning Corp.),<br>12 April, 1995 (12.04.95),<br>Full text<br>& JP 7-187640 A        & US 5441765 A<br>& KR 300801 B          & TW 297786 A | 1–14 |
| X | EP 461782 A2  (Dow Corning Corp.),<br>18 December, 1991 (18.12.91),<br>Full text<br>& JP 4-227980 A        & US 5262201 A<br>& KR 9509548 B1        & TW 229235 A | 1–4,12,14 |

| ☒ Further documents are listed in the continuation of Box C. | ☐ See patent family annex. |
| --- | --- |

| * | Special categories of cited documents: | "T" | later document published after the international filing date or priority date and not in conflict with the application but cited to understand the principle or theory underlying the invention |
| --- | --- | --- | --- |
| "A" | document defining the general state of the art which is not considered to be of particular relevance | | |
| "E" | earlier document but published on or after the international filing date | "X" | document of particular relevance; the claimed invention cannot be considered novel or cannot be considered to involve an inventive step when the document is taken alone |
| "L" | document which may throw doubts on priority claim(s) or which is cited to establish the publication date of another citation or other special reason (as specified) | "Y" | document of particular relevance; the claimed invention cannot be considered to involve an inventive step when the document is combined with one or more other such documents, such combination being obvious to a person skilled in the art |
| "O" | document referring to an oral disclosure, use, exhibition or other means | | |
| "P" | document published prior to the international filing date but later than the priority date claimed | "&" | document member of the same patent family |

| Date of the actual completion of the international search<br>    25 November, 2002 (25.11.02) | Date of mailing of the international search report<br>    10 December, 2002 (10.12.02) |
| --- | --- |
| Name and mailing address of the ISA/<br>    Japanese Patent Office | Authorized officer |
| Facsimile No. | Telephone No. |

Form PCT/ISA/210 (second sheet) (July 1998)

**EP 1 429 376 A1**

## INTERNATIONAL SEARCH REPORT

International application No.

PCT/JP02/08756

| C (Continuation). DOCUMENTS CONSIDERED TO BE RELEVANT | | |
|---|---|---|
| Category* | Citation of document, with indication, where appropriate, of the relevant passages | Relevant to claim No. |
| X | EP 677872 A1 (Dow Corning Corp.), 18 October, 1995 (18.10.95), Full text & JP 7-283212 A  & US 5547703 A & TW 282563 A | 1-4,12,14 |

Form PCT/ISA/210 (continuation of second sheet) (July 1998)

14